# EUROPEAN PATENT APPLICATION

(11) **EP 3 379 557 A1**
(43) Date of publication of application: **26.09.2018**
(21) Application number: 17000450.1
(22) Date of filing: 20.03.2017
(51) Int. Cl.: H01J 37/28, H01J 37/244, G01N 23/20

(54) **SCANNING TRANSMISSION ELECTRON MICROSCOPE AND METHOD FOR HIGH THROUGHPUT ACQUISITION OF ELECTRON SCATTERING ANGLE DISTRIBUTION IMAGES**

(71) Applicant: TESCAN Brno, s.r.o., 62300 Brno (CZ); Tescan Tempe, LLC., Tempe, AZ 85281 (US)
(72) Inventor: Petras, Stanislav, 38601 Strakonice (CZ); Lencová, Bohumila, 66435 Kurim (CZ); Benner, Gerd Ludwig, 73434 Aalen (DE); Weiss, Jon Karl, Tempe, Arizona 85282 (US)
(74) Representative: Kendereski, Dusan

(57) **Abstract**

The invention provides a method and the electron beam device (1) for high throughput acquisition of electron scattering angle distribution images for structural determination of materials and which can be applied to nanoscale structures. The electron beam device (1) according the invention is optimized for producing the electron scattering angle distribution image of object in low magnification and is characterized in that the electron beam system (1) further comprises a detector scan system (18) optimized for a fast off-axis shift of the electron scattering angle distribution image over the detector plane and beam blanker (23) which is blanking the beam (3,6) while the detector scan system (18) moves the transmitted electron beam (6) between subfields and during the readout of detector (12).

## Description

### FIELD OF THE INVENTION

The present invention is a method and device in the field of structural determination of materials using techniques that are suitable for high-throughput structural analysis, and which can be applied to nanoscale structures.

### BACKGROUND OF THE INVENTION

Many solid materials are formed of small particles or regions which at a microscopic level are composed of atoms in some arrangement. The knowledge of the atomic structure is essential for understanding the properties of the materials. This information about the atomic structure is generally obtained by diffraction techniques using X-Rays, neutrons or electrons.

X-Ray diffraction (XRD) is a technique providing an average structure, usually of a volume no less than about 1 micrometer cubed. However many new materials are composed of particles which are significantly smaller than 1 micrometer, which makes determination of atomic structure with X-Rays difficult or impossible.

Electron diffraction (ED) has some advantages over XRD for nanocrystalline materials. First, the strength of scattering of electrons from atoms is several orders of magnitude higher than the strength of X-Ray scattering, which makes the ED signal much higher intensity than the XRD signal for small particles. Additionally, ED can happen from a volume as small as 1 nanometer cubed without any of the artifacts seen in XRD patterns from nanocrystals.

The problem with using ED for determining atomic structure and crystal orientation is that the high strength of the scattering of electrons leads to ED patterns that are difficult to interpret, especially by automated algorithms. To minimize the effect of this so-called "dynamical diffraction", Precession Electron Diffraction (PED) was developed. In this technique, instead of using a stationary electron beam on the specimen to produce ED patterns, the electron beam is tilted by a small angle (typically 0.3-3.0 degrees) and then the tilt axis is rotated (precessed) about the optical axis. This precession happens during the recording of the ED pattern, so the net pattern is the average of the diffraction patterns from all incident beam directions. The result of the precession is to "smear out" the dynamical part of the diffraction so all that is visible is the so-called "kinematical" spots. Diffraction patterns formed in this way are called PED patterns.

To determine the variation in atomic structure or crystal orientation within a specimen, the electron beam must be moved to multiple positions, and an ED or PED pattern must be recorded from each position. The quality of the measurement is affected by the quality of the recorded diffraction patterns, and also by the number of positions recorded. The number of positions is limited mainly by the recording speed of the camera used for recording the ED patterns, but increasing the recording speed can also reduce the quality of the ED patterns. Therefore, it is critical to select a configuration for recording the ED patterns that optimizes both the recording speed and the detector sensitivity.

Current systems for recording PED patterns are limited in either speed or in sensitivity. In patent US 8253099 the PED patterns are collected using a digital camera (e.g. CCD or CMOS) outside of the microscope which records an image of the PED pattern projected on a TEM fluorescent screen inside the microscope. The image is transferred to the camera by means of an optical lens focused through a viewing window onto the fluorescent screen. The cameras used in this configuration can read out fairly fast (over 100 frames/second), but suffer from low sensitivity due to the relatively low light gathering capability of the camera because of its distance from the fluorescent screen.

So-called "on-axis" cameras can also be used for recording PED patterns. These cameras have their own scintillator (instead of the microscope fluorescent screen) usually coupled to the camera sensor using fiber optics (instead of a lens), so they can gather virtually all of the light produced by the scintillator. These cameras are very sensitive, but they can typically read out only 10-100 PED patterns per second.

It is therefore necessary to have a camera that has high sensitivity, but also that can be read out very quickly. There is sufficient signal in the PED patterns to record more than 1000 patterns per second, so it would be ideal to design a system which can reach that rate. In addition, it is necessary that the camera readout can be accurately synchronized with both the electron beam position and also with the precession.

### SUMMARY OF THE INVENTION

The embodiment of the invention is a method and device for high throughput electron scattering angle distribution acquisition from an electron transparent sample. The method and device provide for fast analysis of the structure of crystalline and amorphous materials based on fast acquisition of a transmitted signal using one or more detectors. The transmitted signal may produce electron diffraction (ED) patterns, precession electron diffraction (PED) patterns or bright field (BF) and dark field (DF) images.

The device is an electron beam system, preferably a (scanning) transmission electron microscope (STEM) comprising an electron beam source producing a primary electron beam with energy typically up to 300keV propagating along an optical axis. Downstream of the electron beam source follows a condenser lens system for defining the beam shape, size and convergence angle. The condenser lens system may be followed by a condenser objective lens system that may comprise Fourier lenses or common condenser objective lenses typically with at least an upper pole piece and a lower pole piece. The condenser objective Fourier lenses compared to common condenser objective lenses generate two diffraction images which are positioned before the virtual image generated by the condenser objective Fourier lens. The field of the condenser objective Fourier lens upstream of the object generates a finely focused spot from the primary electron beam in the object plane. The field below the object generates in the back focal plane an electron scattering angle distribution image, in general a diffraction pattern, of the electrons scattered by the object. The objective lens system is followed by a projection lens system.

The projection lens system may be positioned between the object situated in object plane and detector plane and may be optimized for transferring the image of the electron scattering angle distribution in the back focal plane of the objective lens system onto a detector plane with low magnification. The magnification may be in the range between 1.5 and 15. The projection lens system may consist of three projection lenses. The first projection lens may create a virtual scattering angle distribution image behind the second projection lens which in combination with the third projection lens is used to adjust the desired size of the scattering angle distribution image projected on the detector plane. At the detector plane may be a detector optimized for digitally recording two-dimensional intensity distributions of electrons. The size of the electron scattering angle distribution image at the detector plane may be such that a range of scattering angles up to 120 mrad covers an area of 256x256 pixels on the detector. The electron scattering angle distribution image may have a different size but must have enough pixels to be able to analyse the scattering angle distribution image. To achieve higher magnifications of the scattering angle distribution image each projection lens may generate a real image. In this case the magnification range may be between 10 and 300 times. The device may further comprise a scan and descan system and a precession and deprecession system that may comprise electromagnetic or electrostatic deflectors and may be operated independently or simultaneously in a synchronized manner. The scan system may be arranged upstream of the object plane closer to electron source and is optimized for step by step scanning of the primary electron beam over the object plane. The descan system positioned downstream of the object may deflect the transmitted electron beam back to the optical axis of the device. The precession system positioned upstream of the object plane may be used to tilt the electron beam by a small angle with respect to the optical axis or the shifted axis, typically 0.3-3.0 degrees, and then rotate around the optical axis or the shifted axis targeting a point at the object plane where the shifted axis is approximately parallel with the optical axis. The deprecession system placed downstream of the object may be used to compensate the precession after the beam has passed through the object in order to achieve a stationary electron scattering angle distribution image (diffraction pattern).

The device may further comprise a detector scan system positioned upstream from the detector and downstream the objective lens system preferably underneath the projection lens system. The detector scan system is dedicated for deflection of the electron scattering angle distribution image off of the optical axis of the device and for shifting the electron scattering angle distribution image stepwise over the detector with a step size preferably one diameter of the scattering angle distribution image. The device may include a beam blanker which is responsible for fast (in range of nanoseconds) beam blanking while the detector scan system moves the transmitted electron beam between subfields and during the readout of detector.

The detector may be at least one two-dimensional, multi-pixel detector (eg. CMOS, CCD, image plate, multichannel plate) or a combination of two or more single- or multi-pixel detectors. The detector may be positioned downstream of the detector scan system. The detector may have a readout interval longer than the time needed to scan at least two electron scattering angle distribution images with the detector scan system so that more than one electron scattering angle distribution image can be exposed on the detector plane within one readout interval of the detector. The electron scattering angle distribution image may be formed and scanned over the detector plane by a beam scanning protocol controlled by a control unit. This protocol may define: the setup of the condenser, objective and projection lens systems for achieving low magnification of the electron scattering angle distribution image at the detector plane; the setup of beam blanker and the scan and/or precession system and the the descan and/or deprecession system for selecting the scan mode (for example raster or line), scan speed, scan area and precession angle and precession speed; the setup of the detector scan system for selecting the distance and direction between positions of the electron scattering angle distribution images on the detector; and synchronization of the beam blanker, scan, descan, precession, deprecession and detector scan systems with each other and with the detector readout.

Furthermore the possibility to acquire a multiple or a large number of electron scattering angle distribution images in a short time and the possibility to store the raw data in a storage device allows post processing of the data. Specific areas from the electron scattering angle distribution images may be selectively evaluated. Selected areas in the scattering angle distribution images may be extracted or integrated by software and so called dark field, bright field, annular dark field, annular bright field, high angle annular dark field images or any other available image may be generated from the raw data.

The method according to the invention allows high throughput acquisition of electron scattering angle distribution images of electron transparent objects and comprises the steps of: providing an object comprising particles which may be in random orientations and may generate a characteristic electron scattering angle distribution; acquiring electron scattering angle distributions from at least two discrete locations within an object plane, wherein the electron beam used to obtain the electron scattering angle distribution image may be scanned across the object plane and the related electron scattering angle distribution may be deflected from the optical axis after transmission through the sample by a detector scan system according the beam scanning protocol and scanned over discrete areas on the detector plane so that at least two electron scattering angle distribution images are exposed before the readout of the detector takes place. By this process multiple electron scattering angle distribution images may be aquired during one readout period.

Furthermore the obtained scattering angle distribution images may be post processed and dark field, bright field, annular dark field, annular bright field, high angle annular dark field images or any other type of acquired images may be extracted and evaluated with software or the intensities of diffraction spots may by integrated to get the overall intensity of selected area. The method may be applied to the STEM described above or any other device containing the detector scan system according to the invention and which is able to create the electron scattering angle distribution image with low magnification.

The method according to the invention further uses a scanning protocol for controlling and setup of the device and the detector scan system which may operate in raster scan mode, meander scan mode, spiral scan mode or may use any combination of these scan modes.

### BRIEF DESCRIPTION OF THE DRAWINGS

FIG. 1 is a schematic diagram of an example of an embodiment of a scanning transmission electron microscope (STEM) equipped with condenser Fourier objective lens.
FIG. 2 is a schematic diagram of a further example of an embodiment of a scanning transmission electron microscope (STEM) equipped with a classical condenser objective lens.
FIG. 3 is a schematic diagram of the detector scan system
FIG. 4 is a top down view of the detector
FIG. 5 is diagram with an example of the subfield scan strategy.

### DETAILED DESCRIPTION OF THE PREFERRED EMBODIMENTS

Drawings below describe the examples of embodiments of a STEM according to the invention for producing low magnification electron scattering image and for acquiring multiple electron scattering angle distribution images with the benefit of increasing speed of image acquisition. Further drawings describe the methods for acquiring the multiple scattering distribution images by the detector within one readout period.

The devices and methods described herein are not the exhausting examples of the devices and methods. It may be obvious to a person skilled in the art that other devices and methods may fulfill the nature of the invention according to the description of the invention.

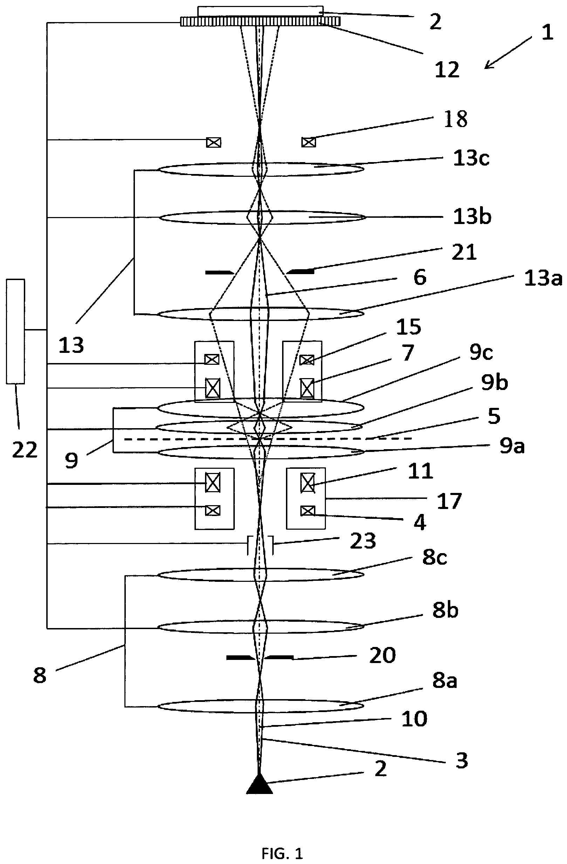

Figure 1 schematically shows an electron beam system 1 suitable for acquiring multiple low magnification electron scattering angle distribution images 16 (not shown).

The electron beam system 1 is a scanning transmission electron microscope (STEM) comprising a primary electron beam source 2 generating a primary electron beam 3. The primary electron beam source may be a field emission, Schottky, thermionic emission type or others. The electron beam system further comprises a means for guiding the primary electron beam 3 and transmitted electron beam 6 containing a condenser lens system 8, objective lens system 9 and projection lens system 13. The shown condenser lens system 8 includes three lenses 8a, 8b and 8c for defining the size and convergence angle of the primary electron beam 3. The objective lens system 9 is a Fourier type lens system where the object (not shown) situated in the object plane 5 lies above the center of the pole piece gap and the magnetic field of the objective lens 9 is strong enough to have the effect of three lenses. The lens 9a above the sample focuses the primary electron beam 3 and targets a point in the object plane 10. The two objective lenses 9b and 9c downstream of the sample generates a first and second electron scattering angle distribution image 16 which is transferred by the projection lens system 13 to the detector 12. The projection lens system 13 is shown as three lenses 13a, 13b and 13c for creating a low magnification electron scattering angle distribution image 16 to illuminate a reduced subfield 19 (not shown) of the detector 12.

The electron beam system 1 further comprises a condenser aperture 20 and field limiting aperture 21. The condenser aperture 20 is positioned upstream of the object plane 5 preferably below the first condenser 8a and depending on the position of the source image provided by condenser 8a defines the beam current. The condenser lenses 8b and 8c are then used to adjust the size and the convergence angle of the focused spot. The field limiting aperture 21 is positioned downstream of the object plane 10 and together with the projection lens system 13 can be used to restrict the electron scattering angle range and to give a sharp cut-off of the electron scattering angle distribution image 16 to limit the interaction from the adjacent subfields 19 (not shown).

The electron beam system 1 further comprises a scan system 4 for scanning of the primary electron beam 3 over the object plane 5, where the primary electron beam 3 interacts with the object in object plane 5, and forms the transmitted electron beam 6 in the form of an electron scattering angle distribution image 16. Downstream of the objective lens 9 the transmitted electron beam 6 is deflected by a descan system 7 back to the optical axis 10 of the electron beam system 1. The scan system 4 may be further combined with a precession system 11 used to tilt the primary electron beam 3 by a small angle with respect to the optical axis 10 or shifted axis approximately parallel with the optical axis 10, typically 0.3-3.0 degrees, and then rotate the tilted primary electron beam 3 around the optical axis 10 or shifted axis targeting a single point in the object plane 5 (respectively around the central ray if the primary electron beam 3 is scanned). The deprecession system 15 positioned downstream of the object plane 5 is used to compensate the effect of the precession system 11, in order to achieve a stationary electron scattering angle distribution image 16 (diffraction pattern) at the detector plane 14 of the detector 12. The scan system 4 along with the precession system 11 as well as the descan system 7 along with the deprecession system 15 may be situated in shared housing 17.

Upstream of the detector 12 the transmitted electron beam 6 is deflected by a detector scan system 18. The detector scan system 18 is dedicated for deflecting the transmitted electron beam 6 out of the optical axis 10, creating a scattering angle distribution image 16 which may be positioned away from the optical axis 10 and the detector scan may be shifted stepwise over the detector 12. The readout interval of the detector 12 is set up to be long enough for scanning at least two electron scattering angle distribution images 16 on the detector 12 during one readout interval. In the period of stepwise move and readout interval the beam is blanked with a beam blanker 23. The beam blanker is able to shift the primary electron beam 3 or transmitted electron beam 6 so that no electron scattering angle distribution image 16 is reaching the detector 12.

The detector 12 is a multi-pixel detector (e.g. CMOS, CCD, image plate, multichannel plate) with a detector plane 14 facing the detector scan system 18. The images captured on the detector 12 are stored in image storage device 24.

The electron scattering angle distribution image 16 may be formed and scanned over the detector plane 14 (not shown) according a beam scanning protocol controlled by the control unit 22. This protocol may define: the setup of the condenser lens system 8, objective lens system 9 and projection lens system 13 for achieving low magnification of the electron scattering angle distribution image 16 at the detector plane 12; the setup of the scan system 4 and/or the precession system 11 and the descan system 7 and/or the deprecession system 15 for selecting the scan mode (for example raster or line), scan speed, scan area and precession angle and precession speed; the setup of the detector scan system 18 for selecting the distance and direction between positions of the electron scattering angle distribution images 16 on the detector 12; and synchronization of the beam blanker 23, the scan system 4, descan system 7, precession system 11, deprecession system 15 and detector scan systems 18 with each other and with the detector 12 readout.

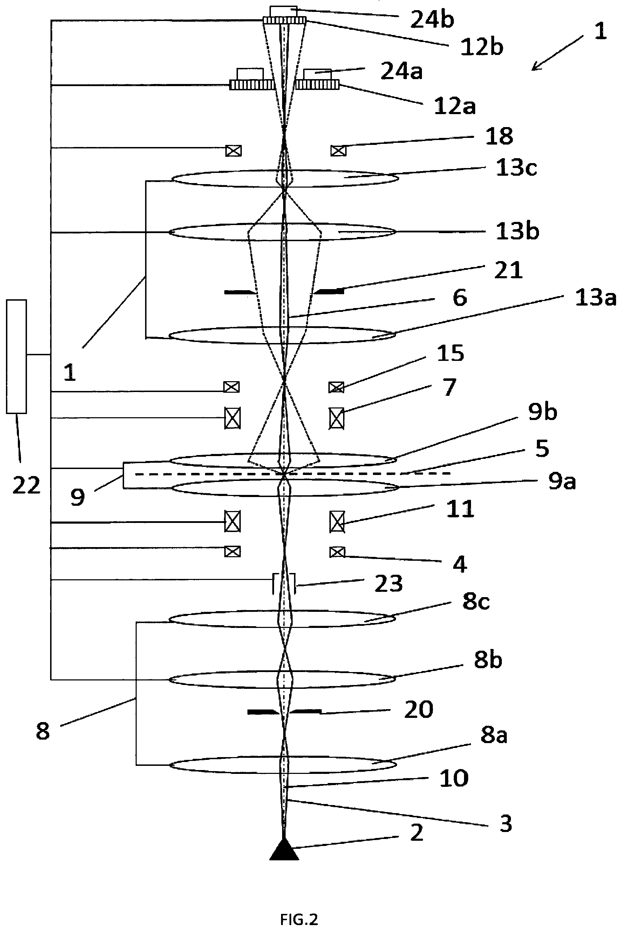

Figure 2 schematically shows another example of an electron beam system 1 suitable for acquiring multiple low magnification electron scattering angle distribution images 16. Compared to Fig. 1 the objective lens system 9 is designed as common condenser objective lens type. In this type compares to the Fourier type lens, the sample is arranged in the center of the pole piece gap, and the field below the sample only has the effect of one objective lens and therefore only generates a single diffraction image (and a real image close to the first projector lens 13a). The scan system 4, descan system 7, precession system 11 and deprecession system 15 are designed as independent systems. The electron beam system 1 is equipped with another detection system comprising at least two detectors 12a and 12b from which at least one is a two-dimensional detector 12. Detectors 12a, 12b detect transmitted electrons which have scattered at different ranges of angles or are deflected by detector deflection system 18 at different range of angles. The images captured on the detectors 12a and 12b are stored in image storage devices 24a and 24b.

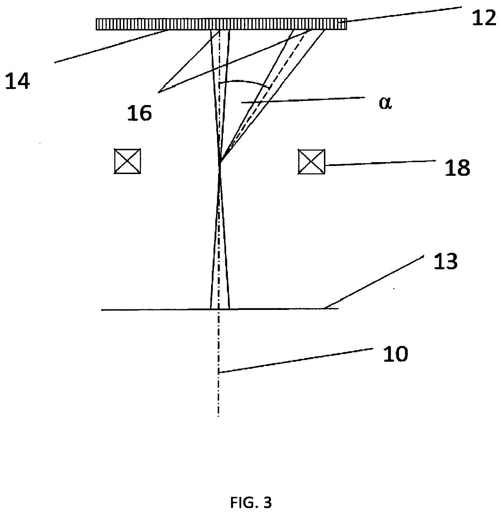

Figure 3 schematically shows a preferred embodiment of a detector scan system 18. The detector scan system 18 is positioned downstream of the projection lens system 13. Application of a voltage to the detector scan systems 18 deflects the transmitted electron beam 6 by an angle a from the optical axis 10 and creates a scattering angle distribution image 16 on the detector plane 14 which may be positioned off of the optical axis. A stepwise change of the voltage on the detector scan system 18 will scan the scattering angle distribution image 16 stepwise over the detector plane 14. Multiple images are then created by two or more electron scattering angle distribution images 16.

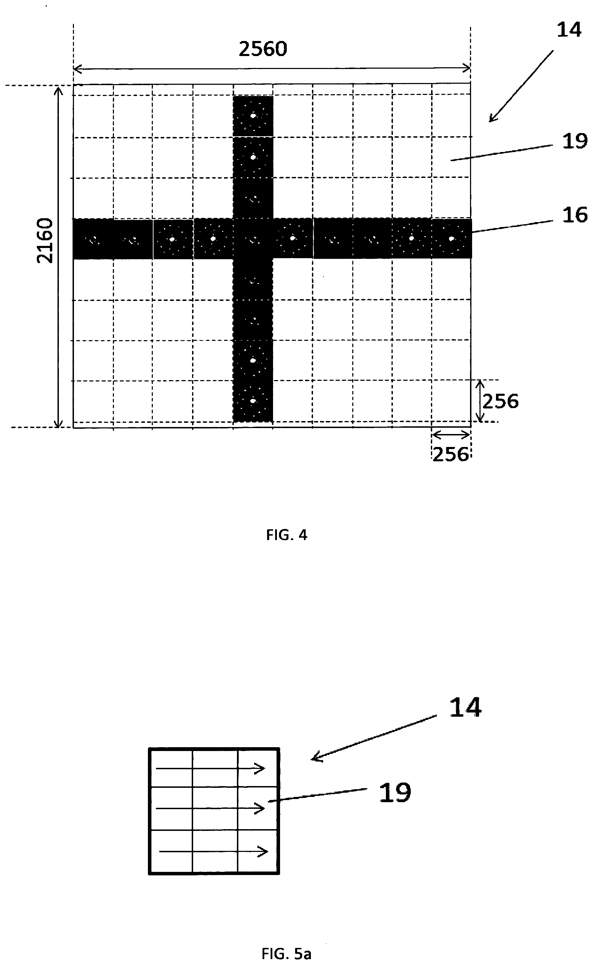

Figure 4 schematically shows a top down view of the detector 12. The detector plane 14 may be an imaging surface of a CMOS chip with a pixel resolution of 2560 x 2160 pixels. This detector plane 14 may be subdivided into subfields 19 of a size that may optimally correspond with the diameter of the scattering angle distribution image 16 so that the diameter of the scattering angle distribution image 16 fits into a subfield 19. For example, if the diameter of the scattering angle distribution image 16 is 256 pixels, up to 80 scattering angle distribution images 16 may be placed side by side on a detector 14 with 2560 x 2160 pixels before readout takes place. Alternatively, the diameter of the scattering angle distribution image 16 may be adjusted to another size so that more than one scattering angle distribution image 16 may be recorded on the detector 14 before readout takes place.

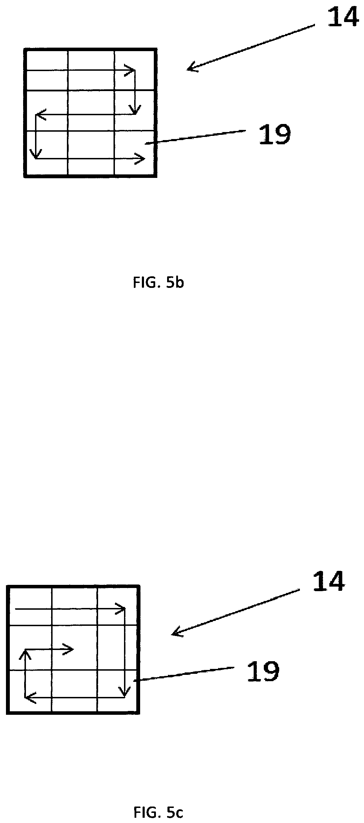

Figure 5 Shows an example of the sub-field scan strategy. On Fig. 5a is a raster scan strategy where the detector scan system 18 deflects the scattering angle distribution image 16 stepwise over the subfields 19 in straight parallel lines with all lines in the same direction. When the transmitted electron beam 6 reaches the end of a line the scattering angle distribution image 16 is moved to the beginning of the next line. FIG. 5b shows the meander scan strategy where the scattering angle distribution image 16 is not moved to the beginning of the next line but is moved to the line just below the current line and continues to move in the opposite direction to the current line. FIG. 5c shows the spiral scan strategy where the scattering angle distribution image 16 is moved in a spiral manner. These strategies are applied until more than two subfields 19 are exposed.

### LIST OF MARKS

- 1-: Electron beam system
- 2-: Electron beam source
- 3-: Primary electron beam
- 4-: Scan system
- 5-: Object plane
- 6-: Transmitted electron beam
- 7-: Descan system
- 8-: Condenser lens system
- 9-: Objective lens system
- 10-: Optical axis
- 11-: Precession system
- 12-: Detector
- 13-: Projection lens system
- 14-: Detector plane
- 15-: Deprecession system
- 16-: Electron scattering angle distribution image
- 17-: Housing
- 18-: Detector scan system
- 19-: Subfield
- 20-: Condenser aperture
- 21-: Field limiting aperture
- 22-: Control unit
- 23-: Beam blanker
- 24-: Image storage device

## Claims

1. A method for high throughput electron scattering angle distribution image (16) acquisition from an object, by providing an object and obtaining multiple electron scattering angle distribution image (16) of the object, wherein the multiple electron scattering angle distribution image (16) is created by exposing at least two electron scattering angle distribution images (16) step by step over discrete areas on a detector (12) within one readout interval of the detector (12) according a beam scanning protocol.

2. The method according to claim 1 wherein the electron scattering angle distribution image (16) is an electron diffraction pattern.

3. The method according to claim 2 wherein the electron diffraction pattern is a precession electron diffraction pattern.

4. The method according to claim 2 wherein the electron diffraction pattern size at the detector (12) is smaller than the detector (12) size.

5. The method according to claim 4 wherein the beam scanning protocol provides a scan mode for step by step exposure of the electron diffraction pattern on each of the multiple subfields (19) of the detector (12).

6. The method according to claim 1 wherein the method allows post processing of raw data acquired from the detector (12).

7. The method according to claim 6 wherein the raw data are post processed at least by one of a procedure of area selection and integration.

8. A scanning transmission electron microscope comprising an electron beam source (2) configured to provide a primary electron beam (3), a condenser lens system (8), an objective lens system (9), a projection lens system (13) configured to generate a low magnification image of an electron scattering angle distribution (16), a detector (12) optimized for recording and readout of an electron scattering angle distribution and a control unit (22), for generating a stationary image of the electron scattering angle distribution (16) **characterized in that** the electron beam system (1) further comprises a detector scan system (18) optimized for a fast off-axis shift of the electron scattering angle distribution image (16) over the detector plane (14).

9. The scanning transmission electron microscope according to claim 8 comprising a beam blanker (23) for blanking the primary electron (3) beam during the subfield (19) shift and detector (12) readout.

10. The scanning transmission electron microscope according to claim 8 **characterized in that** the detector scan system (18) is positioned downstream the objective lens system (9).

11. The scanning transmission electron microscope according to claim 8 **characterized in that** the electron beam system (1) further comprises a precession (11) and deprecession system (15).

12. The scanning transmission electron microscope according to claim 8 **characterized in that** the electron beam system (1) further comprises an image storage device (24).

13. The scanning transmission electron microscope according to claim 12 **characterized in that** the electron beam system (1) further comprises software for post processing of stored images.

14. The scanning transmission electron microscope according to claim 8 **characterized in that** the detector scan system (18) scans at least two scattering angle distribution images (16) (from at least two different object positions) on the detector (12) within one readout interval of the detector (12).

15. The scanning transmission electron microscope according to claim 8 **characterized in that** the size of the electron scattering angle distribution image (16) at the detector plane (14) is less than half the size of the detector (12).
